# EUROPEAN PATENT APPLICATION

(11) **EP 4 801 205 A1**
(43) Date of publication of application: **02.09.2026**
(21) Application number: 24881055.8
(22) Date of filing: 19.06.2024
(51) Int. Cl.: H05K 5/02

(54) **METAL DECORATIVE PART, SHELL AND ELECTRONIC DEVICE**

(30) Priority: 24.10.2023 CN 202322858860 U
(71) Applicant: BYD Company Limited, Shenzhen, Guangdong 518118 (CN)
(72) Inventor: YANG, Jingjie, Shenzhen, Guangdong 518118 (CN); LUO, Fuhua, Shenzhen, Guangdong 518118 (CN); MA, Lan, Shenzhen, Guangdong 518118 (CN); CHEN, Liang, Shenzhen, Guangdong 518118 (CN)
(74) Representative: Mathys & Squire
(86) International application number: PCT/CN2024/100131
(87) International publication number: WO 2025/086678

(57) **Abstract**

A metal trim (104), a shell and an electronic device. At least part of a surface of the metal trim (104) is provided with an uneven sandy layer (110). A plurality of spaced recesses (111) are provided in the sandy layer (110). A raised top surface (112) is formed between two adjacent recesses (111). Each recess (111) comprises a recess bottom surface (111a) and recess side surfaces (111b) arranged on two sides of the recess bottom surface (111a), the glossiness of the recess bottom surface (111a) in the recess (111) being greater than that of the raised top surface (112).

## Description

This application claims priority to Chinese Patent Application No. 202322858860.6, filed with the China National Intellectual Property Administration on October 24, 2023 and entitled "METAL TRIM, HOUSING, AND ELECTRONIC DEVICE" which is incorporated herein by reference in its entirety.

### TECHNICAL FIELD

This application relates to the field of decoration technologies, and in particular, to a metal trim, a housing, and an electronic device.

### BACKGROUND

As people's living standards are improving, users have increasingly higher requirements for the appearance of electronic devices. Electronic devices with personalized decorative textures are becoming popular among people.

At present, metal trims have dull lusters due to opacity. As a result, the metal trims have poor decorative effects and lack competitiveness.

### SUMMARY

A technical problem to be resolved in embodiments of this application is to provide a metal trim, a housing, and an electronic device that have good light and shadow reflection effect.

According to a first aspect, this application provides a metal trim, wherein an uneven sandy layer is disposed on at least a part of a surface of the metal trim; and
the sandy layer is provided with a plurality of grooves that are spaced apart, a convex top surface is formed between two adjacent grooves, the groove includes a groove bottom surface and a groove side surface that is disposed on each of two sides of the groove bottom surface, and gloss of the groove bottom surface is greater than gloss of the convex top surface.

With reference to the first aspect, in a possible embodiment, gloss of the groove side surface is greater than the gloss of the convex top surface.

With reference to the first aspect, in a possible embodiment, a difference in gloss between the groove side surface and the convex top surface is at least 10 GU, and a difference in gloss between the groove bottom surface and the convex top surface is at least 10 GU.

With reference to the first aspect, in a possible embodiment, the difference in gloss between the groove side surface and the convex top surface is 40 GU to 80 GU, and the difference in gloss between the groove bottom surface and the convex top surface is 40 GU to 80 GU.

With reference to the first aspect, in a possible embodiment, the gloss of the groove side surface and the gloss of the groove bottom surface are respectively 300 GU to 350 GU, and the gloss of the convex top surface is 220 GU to 280 GU. Because the gloss of the groove bottom surface and the gloss of the convex top surface of the groove are different, there is a difference in light reflection between the groove bottom surface and the convex top surface at viewing angles, thereby improving concave-convex three-dimensional effects of the metal trim. Because the gloss of the groove side surface and the gloss of the convex top surface of the groove are different, there is a difference in light reflection between the groove side surface and the convex top surface at viewing angles, thereby improving concave-convex three-dimensional effects of the metal trim.

With reference to the first aspect, in a possible embodiment, roughness of the groove side surface and roughness of the groove bottom surface are respectively 0.416 µm to 0.436 µm, and roughness of the convex top surface is 0.446 µm to 0.466 µm. The roughness of the groove bottom surface and the roughness of the groove side surface are both smaller than the roughness of the convex top surface, so that difficulty in processing technologies is reduced, and the groove may be formed by chemical polishing using an etching solution. When chemical polishing time is longer, the roughness of the groove bottom surface and the roughness of the groove side surface are lower.

With reference to the first aspect, in a possible embodiment, a material of the metal trim is an aluminum alloy.

With reference to the first aspect, in a possible embodiment, a spacing distance between the two adjacent grooves is 10 µm to 50 µm, a spacing distance between two adjacent convex top surfaces is 10 µm to 50 µm, and a depth of the groove is 5 µm to 15 µm. By controlling the depth of the groove and the spacing distance between the two adjacent grooves, light and shadow reflection of the metal trim can be enhanced, so that the decorative pattern in the metal trim is more prominent.

With reference to the first aspect, in a possible embodiment, the depth of the groove is H, and the spacing distance between the two adjacent grooves is D, where D/8 ≤ H ≤ D/2.

With reference to the first aspect, in a possible embodiment, the groove side surface, the groove bottom surface, and the convex top surface are provided with dye. The dye is disposed in the metal trim, so that the metal trim is more beautiful.

With reference to the first aspect, in a possible embodiment, an anodic oxide film is disposed on each of the groove bottom surface, the groove side surface, and the convex top surface, the anodic oxide film is provided with a micropore, a diameter of the micropore is 5 nm to 20 nm, and the micropore is configured to accommodate the dye. The dye is accommodated in the micropores, so that possibility of fading of the metal trim is reduced.

With reference to the first aspect, in a possible embodiment, a transparent layer is disposed on a surface of the anodic oxide film facing away from the sandy layer, and the transparent layer seals the micropore. By sealing the dye in the micropores through the transparent layer, possibility of fading of the metal trim can be reduced.

With reference to the first aspect, in a possible embodiment, the groove side surface is directly connected to the convex top surface.

According to a second aspect, this application provides a housing, wherein the housing includes the metal trim according to the first aspect and a body, and a surface of the metal trim facing away from the sandy layer is in contact with the body.

According to a third aspect, this application provides an electronic device, wherein the electronic device includes the housing according to the second aspect and a processor, and the processor is accommodated in the housing.

In this application, the sandy layer is provided with the plurality of grooves that are spaced apart, the convex top surface is formed between the two adjacent grooves, the groove includes the groove bottom surface and the groove side surface that is disposed on each of the two sides of the groove bottom surface, and the gloss of the groove bottom surface and the gloss of the groove side surface of the groove are both greater than the gloss of the convex top surface. The groove bottom surface, the groove side surface, and the convex top surface in the sandy layer form a decorative pattern, so that the decorative pattern has stronger three-dimensional visual effect. Because the gloss of the groove bottom surface and the gloss of the groove side surface of the groove are greater than the gloss of the convex top surface, there is the difference in light reflection between the groove bottom surface and the convex top surface, and the difference in light reflection between the groove side surface and the convex top surface. Therefore, the metal trim can have stronger light and shadow reflection, and the decorative pattern in the metal trim can be highlighted more effectively.

### BRIEF DESCRIPTION OF DRAWINGS

To describe the technical solutions of embodiments of this application or the background more clearly, the following describes the accompanying drawings used for describing embodiments of this application or the background.
FIG. 1 is a diagram of a structure of a metal trim before a first surface is sandblasted according to an embodiment of this application;
FIG. 2 is a diagram of a structure of a metal trim in which a first surface is sandblasted to form a sandy layer according to an embodiment of this application;
FIG. 3 is a diagram of a structure of a metal trim in which a sandy layer is coated with photoresist according to an embodiment of this application;
FIG. 4 is a diagram of a structure in which laser engraving is performed on a metal trim coated with photoresist to remove a part of photoresist and expose a part of a sandy layer according to an embodiment of this application;
FIG. 5 is a diagram of a structure in which laser engraving is further performed on the metal trim to increase a recessed depth of an exposed sandy layer in FIG. 4;
FIG. 6 is a diagram of a structure of a metal trim in which the exposed sandy layer is etched to form a groove in FIG. 5;
FIG. 7 is a diagram of a structure of a metal trim coated with photoresist after being stripped according to an embodiment of this application;
FIG. 8 is a diagram of a structure of a metal trim after being dyed according to an embodiment of this application;
FIG. 9 is a diagram of a structure of an electronic device according to an embodiment of this application; and
FIG. 10 is a diagram of a structure of a housing according to an embodiment of this application.

### Reference numerals:

100: first surface; 110: sandy layer; 111: groove; 111a: groove bottom surface; 111b: groove side surface; 112: convex top surface; 120: photoresist; 200: second surface; 1: electronic device; 10: housing; 102: processor; 104: metal trim; 106: body.

### DESCRIPTION OF EMBODIMENTS

To make objectives, technical solutions, and advantages of this application clearer, the following further describes this application in detail with reference to the accompanying drawings.

This application provides an electronic device 1. The electronic device 1 includes a processor 102 and a housing 10. The housing 10 accommodates the processor 102, and the housing 10 can protect the processor 102. If the electronic device 1 falls unexpectedly, the housing 10 can prevent the processor 102 from directly colliding with the ground, thereby protecting the processor 102. The housing 10 can be used as a decoration of the electronic device 1, to beautify an appearance of the electronic device 1. The electronic device 1 further includes a display (not shown). In an embodiment, the display may be configured in the form of a liquid crystal display (LCD), an organic light-emitting diode (OLED), or the like. In an embodiment, the housing 10 surrounds the display.

A material of the housing 10 may be metal. A metal housing 10 has higher structural strength. Further, the metal housing 10 has a more beautiful appearance. The metal housing 10 can adapt to more types of processing technologies.

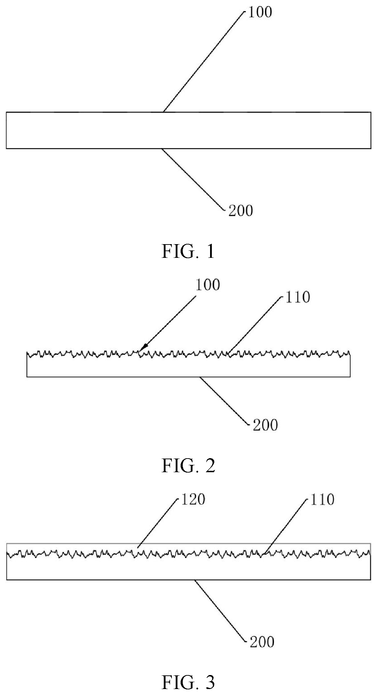

Referring to FIG. 1 to FIG. 8, in a housing 10 provided in this application, the housing 10 includes a metal trim 104 and a body 106, and the body 106 and the metal trim 104 are connected into a whole. A surface of the metal trim 104 facing away from the sandy layer 110 is in contact with the body 106. Referring to FIG. 1 and FIG. 2, a sandy layer 110 is disposed on at least a part of a surface of the metal trim 104, and the sandy layer 110 is an uneven surface. In this application, the uneven sandy layer 110 can be formed on the part of the surface of the metal trim 104 by sandblasting. Specifically, the metal trim 104 includes a first surface 100 and a second surface 200 that are opposite to each other in a thickness direction. Referring to FIG. 2, the first surface 100 is sandblasted to obtain the uneven sandy layer 110. The sandy layer 110 has relatively low gloss, thereby providing anti-glare (AG) effect. When the metal trim 104 is sandblasted, the first surface 100 of the metal trim 104 may be ground and polished by using a grinding machine, and then the first surface 100 may be sandblasted at a rate of 0.1 MPa to 0.8 MPa using 80 meshes to 400 meshes of ceramic sand, glass beads, iron sand, or the like, so that the first surface 100 presents a sandblasted texture.

In this application, gloss may be measured using a gloss meter. A gloss unit (GU) is a measurement scale of the gloss meter. The gloss unit is defined based on a highly polished reference black glass. The reference black glass has a defined refractive index and has a specular reflectance of 100 GU at a specified angle.

Gloss is a capability of a surface to reflect light when an object is irradiated with light, and is usually expressed by multiplying reflectance of a specimen in a mirror (positive reflection) direction relative to reflectance of a standard surface by 100, that is, G = 100 R/R. In the formula, R represents reflectance of a surface of the specimen, and /R represents reflectance of a standard plate. A perfectly polished black glass is used as a reference standard plate. The perfectly polished black glass has a refractive index of 1.568 for a sodium D line, and has specular gloss calibrated to 105 gloss units under each geometric optical condition. Therefore, different values indicate different gloss of a surface of the object. If a result is between 10 GU and 70 GU, a coating may be classified as semi-gloss and measured at this angle. If a result is less than 10 GU, a product may be classified as low gloss and measured at 85°. If a result is higher than 70 GU, a product may be classified as high gloss and measured at 20°.

Specifically, the sandy layer 110 is provided with a plurality of grooves 111 that are spaced apart. A convex top surface 112 is formed between two adjacent grooves 111. Each groove 111 includes a groove bottom surface 111a and a groove side surface 111b that is disposed on two sides of the groove bottom surface 111a. In a possible embodiment, gloss of the groove bottom surface 111a is greater than gloss of the convex top surface 112. In another possible embodiment, the gloss of the groove bottom surface 111a and gloss of the groove side surface 111b of the groove 111 is greater than the gloss of the convex top surface 112. When the gloss of the groove bottom surface 111a and the gloss of the groove side surface 111b of the groove 111 are both greater than the gloss of the convex top surface 112, a user may perceive a visual difference between the groove 111 and the convex top surface 112 at all viewing angles. In an actual application, the groove bottom surface 111a, the groove side surface 111b, and the convex top surface 112 in the sandy layer 110 form a decorative pattern, so that the decorative pattern has stronger three-dimensional visual effect. The groove side surface 111b is directly connected to the convex top surface 112. Because the gloss of the groove bottom surface 111a and the gloss of the groove side surface 111b of the groove 111 are greater than the gloss of the convex top surface 112, there is a difference in light reflection between the groove bottom surface 111a and the convex top surface 112, and a difference in light reflection between the groove side surface 111b and the convex top surface 112. Therefore, the metal trim 104 has reflective variations of light and shadow of the pattern, so that the metal trim 104 can have stronger light and shadow reflection, and the decorative pattern in the metal trim 104 can be highlighted more effectively. The metal trim 104 further includes a pattern-free area, and the pattern-free area may not be provided with texture structures of the groove 111 and the convex top surface 112, so that a sharp contrast is created between the pattern-free area and the pattern, thereby greatly improving visual effect of the pattern.

Generally, when roughness of a metal surface is lower, gloss of the metal surface is higher. To ensure that the gloss of the groove bottom surface 111a and the gloss of the groove side surface 111b of the groove 111 is greater than the gloss of the convex top surface 112, roughness of the groove bottom surface 111a and roughness of the groove side surface 111b of the groove 111 may be less than roughness of the convex top surface 112.

The surface of the object is not an absolutely smooth surface. Specular reflectance (that is, gloss) depends on a refractive index of the object, and is related to surface roughness. When the surface roughness is larger than a wavelength of incident light, the surface has diffuse reflection in addition to specular reflection. When the surface is rougher, the surface has a greater amount of diffuse reflection, a corresponding amount of specular reflection decreases, and gloss becomes weak.

Surface roughness (Surfagauge) measurement methods can be classified into two types: contact measurement methods and non-contact measurement methods. The contact measurement methods mainly include a comparison method, a replica method, and a stylus method. The non-contact measurement methods include a light sectioning method, a real-time holography method, a speckle method, an astigmatic method, an optical heterodyne method, AFM, an optical sensor method, and the like.

A stylus surface roughness measuring instrument is the most commonly used, most convenient, and most reliable surface roughness measuring instrument, and has consistently served as the basis for formulating national standards and international standards. According to different principles of sensors, stylus roughness gauges may include an inductive type, a piezoelectric type, a photoelectric type, a laser type, and a grating type, and may also include a skid-type and a skidless type. The skid-type roughness gauge is only used to measure surface roughness, while the skidless type roughness gauge can be used to measure surface waviness and surface geometry in addition to measuring surface roughness. In the metal trim 104 provided in this application, in order to make a texture structure of the metal trim 104 clearer, a difference in gloss between the groove side surface 111b and the convex top surface 112 is at least 10 GU, and a difference in gloss between the groove bottom surface 111a and the convex top surface 112 is at least 10 GU. In this application, the difference in gloss between the groove side surface 111b and the convex top surface 112 is 40 GU to 80 GU, and the difference in gloss between the groove bottom surface 111a and the convex top surface 112 is 40 GU to 80 GU. Specifically, the roughness of the groove side surface 111b and the roughness of the groove bottom surface 111a are respectively 0.416 µm to 0.436 µm, and the roughness of the convex top surface 112 is 0.446 µm to 0.466 µm. The gloss of the groove bottom surface 111a and the gloss of the groove side surface 111b of the groove 111 are respectively 300 GU to 350 GU, and the gloss of the convex top surface 112 is 220 GU to 280 GU. Because the gloss of the groove bottom surface 111a and the gloss of the convex top surface 112 of the groove 111 are different, there is a difference in light reflection between the groove bottom surface 111a and the convex top surface 112 at viewing angles, thereby improving concave-convex three-dimensional effect of the metal trim 104. Because the gloss of the groove side surface 111b and the gloss of the convex top surface 112 of the groove 111 are different, there is a difference in light reflection between the groove side surface 111b and the convex top surface 112 at viewing angles, thereby improving concave-convex three-dimensional effect of the metal trim 104.

The roughness of the groove bottom surface 111a and the roughness of the groove side surface 111b are both smaller than the roughness of the convex top surface 112, so that difficulty in processing technologies is reduced, and the groove 111 may be formed by chemical polishing using an etching solution. When chemical polishing time is longer, the roughness of the groove bottom surface 111a and the roughness of the groove side surface 111b are lower.

In the metal trim 104 provided in this application, as shown in FIG. 3, in order to form the groove 111 in the sandy layer 110, one of photoresist 120, ink, or glue is coated on the sandy layer 110. Because a bonding force of the photoresist 120 and the metal trim 104 is high, a surface of the photoresist 120 facing away from the surface of the sandy layer 110 is flat. A thickness of the photoresist 120 is 8 µm to 12 µm. After being evenly coated on the sandy layer 110, the photoresist 120 is hard baked at a temperature of 100°C to 180°C for 20 minutes to 60 minutes, enabling the photoresist 120 to be firmly coated on the sandy layer 110. The photoresist 120 is coated on the sandy layer 110 of the metal trim 104. Because a bonding force of fine molecules of the photoresist 120 and a product is high, the photoresist 120 does not produce burrs after laser engraving and is not easy to peel off during etching. Films do not need to be peeled in a technical process, so that operations are simple and costs are low.

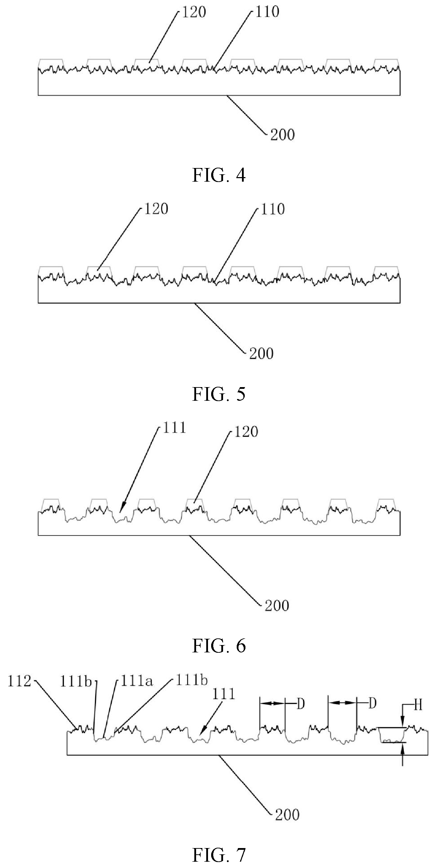

Referring to FIG. 4, FIG. 5, and FIG. 6, after the photoresist 120 is coated on the sandy layer 110, laser engraving is performed on the photoresist 120, to remove a part of the photoresist 120, thereby exposing the sandy layer 110. A texture is first engraved on the photoresist 120 by laser engraving, and a position at which the metal trim 104 is laser engraved can be locally recessed (the sandy layer 110 exposed after laser engraving can be recessed toward the second surface 200). Deeper textural effect can be achieved by further etching, and gloss of an etched area is higher than gloss of a non-etched area. The exposed sandy layer 110 is etched to form the groove 111. Conventional photoresist 120 is used for exposure development, and photosensitivity, acid resistance, and the like of the photoresist 120 need to be adjusted. If the composition is more complex, impact on exposure is greater, acid resistance is better, and exposure is more difficult. Because the laser engraving process has no requirements for photosensitivity of the photoresist 120, acid resistance of the photoresist 120 can be improved infinitely, and laser engraving can be directly performed on the photoresist 120, thereby removing a part of the photoresist 120.

In the metal trim 104 provided in this application, an etching solution used to etch the sandy layer 110 is a mixture of 55% to 75% phosphoric acid, 5% to 15% nitric acid, and 5% to 20% sulfuric acid. Alternatively, the metal trim 104 is etched using a mixture of hydrofluoric acid and sulfuric acid, to form the groove 111. A depth of the groove 111 formed by etching is 5 µm to 15 µm, a spacing distance between the two adjacent grooves 111 is 10 µm to 50 µm, and a spacing distance between two adjacent convex top surfaces 112 is 10 µm to 50 µm.

The depth of the groove 111 is H. A spacing distance between two grooves 111 is D, where D/8 ≤ H ≤ D/2. By controlling the depth of the groove 111 and the spacing distance between the two adjacent grooves 111, light and shadow reflection of the metal trim 104 can be enhanced, so that the decorative pattern in the metal trim 104 is more prominent.

In the metal trim 104 provided in this application, when duration for which the sandy layer 110 exposed on the metal trim 104 after laser engraving is chemically polished using the etching solution is longer, the roughness of the groove bottom surface 111a and the roughness of the groove side surface 111b of the groove 111 formed by chemical polishing are lower. This allows the roughness of the groove bottom surface 111a and the roughness of the groove side surface 111b of the groove 111 to be lower than the roughness of the convex top surface 112, thereby controlling the gloss of the groove bottom surface 111a and the gloss of the groove side surface 111b of the groove 111.

After the sandy layer 110 is etched using the etching solution to form the groove 111, neutralization processing is performed with 200 ml/L to 300 ml/L nitric acid at 15°C to 25°C for 10s to 20s.

Referring to FIG. 7, after neutralization processing, the photoresist 120 on the metal trim 104 is stripped. Specifically, the photoresist 120 coated on the metal trim 104 is removed using a neutral stripper, to expose the convex top surface 112.

In the metal trim 104 provided in this application, a material of the metal trim 104 is an aluminum alloy. The aluminum alloy has high structural strength and a light weight. However, because an aluminum alloy base material is not resistant to acid and alkali corrosion, the photoresist 120 in the metal trim 104 is stripped using the neutral stripper. Therefore, negative effect of corrosion and contamination caused by stripping the photoresist 120 from the metal trim 104 can be reduced.

After the photoresist 120 is stripped from the metal trim 104 using the neutral stripper, the metal trim 104 is washed with deionized water more than one time, and then is dried in a drying oven at a temperature of 60°C to 80°C, to obtain a cleaned and dried metal trim 104. Generally, baking time in the drying oven is 8 minutes to 30 minutes. Metal anodizing is performed on the sandy layer 110 of the metal trim 104 to form an oxide film on the sandy layer 110 of the metal trim 104, dense micropores are formed on a surface of the oxide film, and a diameter of the micropore is 5 nm to 20 nm. A depth of the micropore is much larger than the diameter of the micropore, and a depth of the micropore is 300 times to 700 times a diameter of the micropore.

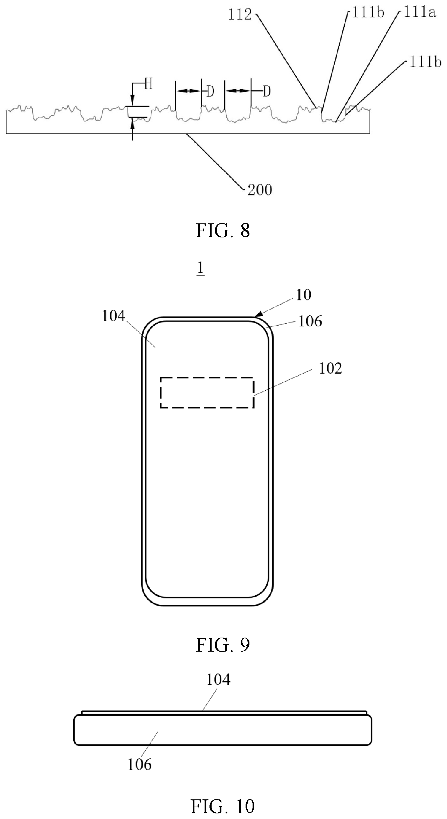

Referring to FIG. 8, the metal trim 104 is anodized, and then the sandy layer 110 of the metal trim 104 is dyed.

After the metal trim 104 is dyed, sealing is performed on the metal trim 104. Specifically, the metal trim 104 is soaked in a chemical agent to generate a transparent film that can seal each micropore, and then seal the dye in the micropores. This reduces possibility of fading of the metal trim 104.

It will be noted that all directional indications (such as up, down, left, right, front, rear...) in embodiments of this application are merely intended to illustrate relative positional relationships and movement of components in a specific posture (as shown in the accompanying drawings). If the specific posture changes, the directional indication will also change accordingly.

In addition, in this application, the descriptions "first", "second", and the like are merely intended for a purpose of description, and will not be understood as an indication or implication of relative importance or an implicit indication of a quantity of indicated technical features. Therefore, a feature limited by "first", "second", or the like may explicitly or implicitly include at least one of the features. In the description of this application, "a plurality of" means at least two, for example, two, three, or the like, unless otherwise expressly and specifically limited.

In this application, unless otherwise specified and limited, terms "connect", "fasten", and the like will be understood in a broad sense. For example, "fasten" may indicate fixed connection, detachable connection, or integrated connection, may indicate mechanical connection or electrical connection, or may indicate direct connection, indirect connection through an intermediate medium, internal communication between two elements, or an interaction relationship between two elements, unless otherwise specified. For those of ordinary skill in the art, the specific meanings of the above terms in this application may be interpreted according to the specific condition.

In addition, the technical solutions of the embodiments of this application may be combined with each other, but only if they are achievable by a person of ordinary skill in the art. When a combination of the technical solutions conflicts with each other or is unachievable, the combination shall be deemed non-existent and outside the scope of protection claimed by this application.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A metal trim (104), wherein an uneven sandy layer (110) is disposed on at least a part of a surface of the metal trim (104); and
the sandy layer (110) is provided with a plurality of grooves (111) that are spaced apart, a convex top surface (112) is formed between two adjacent grooves (111), the groove (111) comprises a groove bottom surface (111a) and a groove side surface (111b) that is disposed on each of two sides of the groove bottom surface (111a), and gloss of the groove bottom surface (111a) is greater than gloss of the convex top surface (112).

2. The metal trim (104) according to claim 1, wherein gloss of the groove side surface (111b) is greater than the gloss of the convex top surface (112).

3. The metal trim (104) according to claim 2, wherein a difference in gloss between the groove side surface (111b) and the convex top surface (112) is at least 10 GU, and a difference in gloss between the groove bottom surface (111a) and the convex top surface (112) is at least 10 GU.

4. The metal trim (104) according to claim 3, wherein the difference in gloss between the groove side surface (111b) and the convex top surface (112) is 40 GU to 80 GU, and the difference in gloss between the groove bottom surface (111a) and the convex top surface (112) is 40 GU to 80 GU.

5. The metal trim (104) according to claim 1, wherein gloss of the groove side surface (111b) and the gloss of the groove bottom surface (111a) are respectively 300 GU to 350 GU, and the gloss of the convex top surface (112) is 220 GU to 280 GU.

6. The metal trim (104) according to claim 1, wherein roughness of the groove side surface (111b) and roughness of the groove bottom surface (111a) are respectively 0.416 µm to 0.436 µm, and roughness of the convex top surface (112) is 0.446 µm to 0.466 µm.

7. The metal trim (104) according to any one of claims 1 to 6, wherein a material of the metal trim (104) is aluminum alloy.

8. The metal trim (104) according to any one of claims 1 to 6, wherein a spacing distance between the two adjacent grooves (111) is 10 µm to 50 µm, a spacing distance between two adjacent convex top surfaces (112) is 10 µm to 50 µm, and a depth of the groove (111) is 5 µm to 15 µm.

9. The metal trim (104) according to claim 8, wherein the depth of the groove (111) is H, and the spacing distance between the two adjacent grooves (111) is D, wherein D/8 ≤ H ≤ D/2.

10. The metal trim (104) according to claim 1, wherein the groove side surface (111b), the groove bottom surface (111a), and the convex top surface (112) are provided with dye.

11. The metal trim (104) according to claim 10, wherein an anodic oxide film is disposed on each of the groove bottom surface (111a), the groove side surface (111b), and the convex top surface (112), the anodic oxide film is provided with a micropore, a diameter of the micropore is 5 nm to 20 nm, and the micropore is configured to accommodate the dye.

12. The metal trim (104) according to claim 11, wherein a transparent layer is disposed on a surface of the anodic oxide film facing away from the sandy layer (110), and the transparent layer seals the micropore.

13. The metal trim (104) according to any one of claims 1 to 12, wherein the groove side surface (111b) is directly connected to the convex top surface (112).

14. A housing (10), comprising the metal trim (104) according to any one of claims 1 to 13 and a body (106), a surface of the metal trim (104) facing away from the sandy layer (110) being in contact with the body (106).

15. An electronic device (1), wherein the electronic device (1) comprises the housing (10) according to claim 14 and a processor (102), and the processor (102) is accommodated in the housing (10).
